# EUROPEAN PATENT APPLICATION

(11) **EP 4 682 936 A1**
(43) Date of publication of application: **21.01.2026**
(21) Application number: 24770208.7
(22) Date of filing: 23.01.2024
(51) Int. Cl.: H01L 21/02, B23K 26/57, H01L 21/205, H01L 21/3065

(54) **SEMICONDUCTOR SUBSTRATE PRODUCTION METHOD, SEMICONDUCTOR SUBSTRATE, AND SEMICONDUCTOR DEVICE**

(30) Priority: 15.03.2023 JP 2023040704
(71) Applicant: Shin-Etsu Handotai Co., Ltd., Tokyo 100-0004 (JP)
(72) Inventor: OHTSUKI Tsuyoshi, Nishishirakawa-gun, Fukushima 961-8061 (JP); MATSUBARA Toshiki, Nishishirakawa-gun, Fukushima 961-8061 (JP); SUZUKI Atsushi, Nishishirakawa-gun, Fukushima 961-8061 (JP); ABE Tatsuo, Nishishirakawa-gun, Fukushima 961-8061 (JP); SATO Michito, Nishishirakawa-gun, Fukushima 961-8061 (JP)
(74) Representative: Schicker, Silvia
(86) International application number: PCT/JP2024/001733
(87) International publication number: WO 2024/190086

(57) **Abstract**

The present invention is a method for producing a semiconductor substrate, the method including the steps of irradiating a surface of a 4H-SiC substrate with a laser to form, within the 4H-SiC substrate, an amorphous layer composed of amorphized silicon and carbon, bonding the 4H-SiC substrate and another support substrate via a thin film to obtain a bonded substrate, separating the 4H-SiC substrate at the amorphous layer from the bonded substrate, thereby dividing the bonded substrate into a joined substrate in which a surface layer of the 4H-SiC substrate is transferred as a 4H-SiC layer on the support substrate, and a separated substrate that is the 4H-SiC substrate after the surface layer has been separated, etching a separation surface of at least one of the joined substrate or the separated substrate, both of which have been subjected to the step of separating, by plasma etching, and performing epitaxial growth on at least one of the joined substrate or the separated substrate. This provides a method for producing a semiconductor substrate that can produce the semiconductor substrate with a lower cost and a higher quality.

## Description

### TECHNICAL FIELD

The present invention relates to a method for producing a semiconductor substrate, a semiconductor substrate, and a semiconductor device.

### BACKGROUND ART

SiC is expected to be a semiconductor material for a variety of semiconductor devices, such as power devices and high-frequency devices, due to a wide bandgap of 2.2 to 3.3 eV, which provides high dielectric breakdown strength and high thermal conductivity.

However, it has been reported in Non Patent Document 1 that in devices using SiC, a SiC substrate production step and a subsequent epitaxial step account for half of costs, and thus, reducing the costs of the substrates is of significant importance.

For this cost reduction method, a method has been proposed in which H⁺ ions are implanted into a 4H-SiC substrate to perform a substrate separation. Regarding this H⁺ implantation into the SiC, several prior arts have been reported.

Patent Document 1 discloses a method in which two SiC single-crystal wafers are provided, and oxidation layers are formed on each of the wafers. After hydrogen ions are implanted into one of substrates, the bonding and integration are performed at room temperature via the oxidation layers. Subsequently, heat treatment at a temperature of 500°C or higher is performed, thereby splitting the SiC single-crystal wafers along the hydrogen ion-planted portion to produce a substrate for a semiconductor electric device.

According to this method, oxide films are present at the bonded portion; accordingly, the oxide film functions as an insulating layer when configuring a vertical device, thereby significantly limiting functionality of the power device substrate.

Moreover, Patent Document 2 discloses a method to bond a single-crystal SiC substrate, in which H⁺ is implanted, to a polycrystal SiC substrate, and then separate the single-crystal and the polycrystal, respectively. This method presents difficulty due to a cost increase caused by performing separation twice, and a need to perform the separation at respective predetermined steps.

Patent Document 3 discloses a method for transferring a high-resistance substrate having a low defect density, with a focus on impurity concentration and defect density, by using H⁺ implantation. While this method is a method for reducing defects present in an original substrate, references regarding the substrate after separation are absent.

Furthermore, Patent Document 4 discloses a technique for a base of substrate separation using H⁺ ion implantation, and while the function of a diffusion barrier (oxygen diffusion barrier) is referred to, the substrate after separation is not referred to.

Furthermore, Patent Document 5 also discloses a method for producing a variety of substrates using separation techniques using H⁺. In this method, InGaN is epitaxially grown after polishing or dry etching of the substrate surface. However, no description is provided regarding the handling of the separated substrate.

In addition, Patent Document 6 discloses a method including: a device is formed on a silicon carbide substrate; a protective film is formed on the device; ions are then implanted into the substrate; the silicon carbide substrate is bonded to a support substrate, and then the high-temperature annealing is performed; and the separated substrates are reused. However, no disclosure is also provided regarding handling of the substrates after separation.

Moreover, Patent document 7 discloses a method in which, by applying H⁺ separation, after ion implantation into a single-crystal SiC, a polycrystal SiC is formed on the opposite side, followed by annealing, and then a substrate is separated at the ion-implantation surface, and the SiC, in which the separation surface has been polished, is epitaxially grown. As described above, as for substrate separation techniques using H⁺, no specific method is disclosed regarding the reuse of the separated substrate.

Moreover, as methods for forming a support substrate during separation after H⁺ implantation, Patent Document 8 discloses a growth of polycrystalline SiC on the substrate, in which H⁺ has been implanted, at a temperature of 1000 to 1600°C. Patent Document 9 discloses growth of a substrate, in which H⁺ has been implanted, by DLI-CVD (Direct Liquid Injection-CVD). Patent Document 10 discloses methods, such as sintering and liquid-phase deposition, for the substrate after H⁺ has been implanted.

These methods are adopted because, as also disclosed in Patent Document 8, bonding SiC to SiC is difficult, and bonding via W or Mo has been pointed out to involve problems due to the presence of an intervening metal.

However, when deposition is performed on the support substrate at high temperature following H⁺ implantation in these ways, separation at the H⁺ implantation layer may occur during the deposition. Moreover, the substrate having the H⁺ implantation layer itself, which is intended for reuse, is exposed to high temperature and subjected to not only a change in crystallinity but also the formation of a polycrystalline layer on the side surface, thereby hindering the reuse.

### CITATION LIST

### PATENT LITERATURE

Patent Document 1: JP H11-003842 A
Patent Document 2: JP 2016-018890 A
Patent Document 3: JP 2014-022711 A
Patent Document 4: JP 2007-329470 A
Patent Document 5: JP 2013-513963 A
Patent Document 6: JP 2022-140396 A
Patent Document 7: WO 2022/158085 A1
Patent Document 8: JP 2022-542224 A
Patent Document 9: JP 2023-502571 A
Patent Document 10: JP 2023-502572 A

### NON PATENT LITERATURE

Non-Patent Document 1: Iwamuro, "Progress in High Performance and High Reliability of SiC MOSFETs," proceedings of the Special Open Symposium of the Japan Society of Wide Gap Semiconductors, 2022, the Japan Society of Wide Gap Semiconductors.
Non-Patent Document 2: H. Biard, W. Schwarzenbach, S. Odoul, I. Radu, A. Potier, M. Ferrato, E. Guajioty, "Tailored polycrystalline substrate for SmartSiCTM substrates enabling high performance power devices", ICSCRM2022, 2022.
Non-Patent Document 3: Suga, "Surface activated bonding at room temperature and its bonding mechanism", Applied Physics, 89(9), P. 498, 2020, the Japan Society of Applied Physics.

### SUMMARY OF INVENTION

### TECHNICAL PROBLEM

As described above, 4H-SiC is expected to be used in high-voltage devices; however, the high cost of the substrates remains a problem, and a way to reduce the cost of bulk substrates remains a challenge. To address this, techniques have been proposed in which H⁺ ions are implanted and the substrate is subsequently separated. In such cases, cost reduction can be achieved by reusing the separated substrate (otherwise, the cost remains high).

Accordingly, how to reuse the separated substrate (how to make it high quality) is of critical importance, and constitutes a core technique for the widespread adoption of a substrate separation technique using H⁺ ions or the like.

On the other hand, the separated substrate after H⁺ ion implantation to separate the substrate has a roughened separation surface, which makes another bonding impossible without planarization, and it is inherently difficult to bond SiC to SiC. Moreover, it is often preferable to planarize the separation surface of the SiC transferred onto the support substrate by the separation and then perform epitaxial growth, or the like, on the separation surface.

However, SiC is a hard-to-process material with high hardness, which results in high planarization cost by polishing, such as CMP, and thus, leads to an increase in an eventual substrate production cost. Furthermore, in a method where the support substrate is grown after H⁺ ion implantation, the separation during the growth of the support substrate, or unintended growth of polycrystalline SiC on the original substrate may hinder the reuse.

The present invention has been made to solve the above-described problem. An object of the present invention is to provide a method for producing a semiconductor substrate, which can produce a high-quality semiconductor substrate at a lower cost by using the separation technique for 4H-SiC.

Moreover, another object of the present invention is to provide a high-quality semiconductor substrate and semiconductor device at a low cost.

### SOLUTION TO PROBLEM

The present invention relates to a method for producing a SiC wafer, which is developed to achieve the above object. More specifically, the present invention pertains to a substrate separation technique utilizing laser irradiation, including bonding to a support substrate and reuse of the substrate after separation, thereby providing a high-quality SiC substrate at low cost. Specifically, the present invention provides a method for producing a semiconductor substrate, the method comprising the steps of:
irradiating a surface of a 4H-SiC substrate with a laser to form, within the 4H-SiC substrate, an amorphous layer composed of amorphized silicon and carbon;
bonding the surface of the 4H-SiC substrate and a bonding surface of another support substrate via a thin film, in which the thin film is formed on at least one of the surface of the 4H-SiC substrate subjected to the laser irradiation or the bonding surface of the support substrate, to obtain a bonded substrate;
separating the 4H-SiC substrate at the amorphous layer from the bonded substrate, thereby dividing the bonded substrate into a joined substrate in which a surface layer of the 4H-SiC substrate is transferred as a 4H-SiC layer on the support substrate, and a separated substrate that is the 4H-SiC substrate after the surface layer has been separated;
etching a separation surface of at least one of the joined substrate or the separated substrate, both of which have been subjected to the step of separating, by plasma etching; and
performing epitaxial growth on at least one of the joined substrate or the separated substrate.

According to such a method for producing a semiconductor substrate, the surface of the 4H-SiC substrate is irradiated with a laser to form the amorphous layer, and then bonded to the support substrate, after which the 4H-SiC substrate is separated along the amorphous layer, thereby transferring the 4H-SiC layer onto the joined substrate.

In the step of irradiating with a laser utilizing the laser as described above, it is possible to introduce damage at a predetermined depth by adjusting a focal position of the laser from the substrate surface. The damage specifically refers to breaking the bonds between silicon and carbon with the laser. These silicon and carbon, being broken, are present in an amorphous state, respectively. The amorphous layer thus formed through such amorphization can be separated by inserting a thin metal-like object laterally. Furthermore, the carbon layer absorbs more light as blackened; consequently, it is possible to separate by irradiating this portion with light to further excite, or to separate by a combination of both methods. When the amorphous layer is used as a separation layer in this way, the separation does not occur even when a certain high temperature is applied, and the step of separation can be performed at any desired stage in the production step.

In this way, in the present invention, the amorphous layer is formed utilizing the laser, and the bonding is then performed. At this time, not only a single crystal but also a polycrystalline body and a sintered body can be used for the support substrate for the 4H-SiC layer, which enables significant cost reduction. Moreover, it has been reported (Non-Patent Document 2) that the use of the polycrystalline body can achieve a greater reduction in substrate resistance, and thus, is more effective. When considering application in vertical devices, in addition to a cost advantage, it is highly effective for improving quality.

Further, by sputtering a thin film, such as silicon, to the bonding surface between a laserirradiated 4H-SiC substrate and the support substrate and bonding each other via this thin film, it becomes possible to bond SiC substrates to each other, which has been difficult to bond when the support substrate is also composed of SiC.

Furthermore, in the present invention, the separated substrate or the joined substrate is subjected to plasma etching on the separation surface to remove the damaged layer and planarize the surface, after which the substrate is reused or epitaxially grown. This enables planarization of SiC, which is a hard-to-process material at a lower cost compared to a polishing such as CMP, and thus, a high-quality substrate can be obtained.

Note that normally, SiC is not easily plasma etched; the etching thereof can be performed due to a weakening effect of the separation surface caused by laser irradiation. By performing epitaxial growth in this way, when a single high-quality SiC substrate can be provided, it is possible to repeatedly produce a high-quality SiC substrate at a lower cost until the 4H-SiC substrate reaches a thickness at which no further surface layer can be separated by repeating the laser irradiation step, bonding step, separation step, etching step, and epitaxial growth step, thereby transferring the surface layer of the 4H-SiC substrate onto a support substrate and forming an epitaxial layer by a vaporphase growth method such as CVD.

In this case, it is possible that in the step of separating, the 4H-SiC substrate is separated by performing light irradiation, impact application, or a combination thereof to the amorphous layer.

In this way, by irradiating the amorphous layer with light and causing it to absorb the light, energy required for the separation can be directly imparted to the amorphous layer.

Moreover, when the bonded substrate is separated by applying an impact to the amorphous layer, the separation can be achieved simply by inserting, for example, a thin metal blade-like object into the amorphous layer, which is advantageous in that the facility required for separation can be simplified.

Moreover, by combining the light irradiation and the impact to perform separation, the time required for separation can be reduced compared to the case where each is applied individually.

In this case, it is possible that in the step of bonding, a silicon thin film is formed as the thin film, and bonding is performed via the silicon thin film.

The silicon thin film is sometimes employed as an underlayer for the epitaxial growth of 4H-SiC, which enables easy bonding with 4H-SiC. In addition, it also allows for easy bonding with the polycrystalline or sintered body of SiC. Therefore, by providing the support substrate composed of polycrystalline SiC, which is less expensive than single-crystal SiC, and forming a thin silicon layer on the bonding surface to achieve bonding via the silicon, bonding can be easier.

In this case, it is possible that in the step of bonding, the silicon thin film is formed by a sputtering method using silicon as a target.

In this way, when the silicon thin film is formed by a sputtering method in which an inert gas such as Ar is ionized and irradiated using silicon as a target, this results in advantages in terms of adhesion and other properties. It has been found that, in this case, the roughness of the bonding surface is preferably 1 nm or less (Non-Patent Document 3).

Moreover, the use of the sputtering method eliminates the need for high-temperature processing of the substrate on which the film is to be formed, and does not roughen the SiC surface of the bonding surface.

In this case, it is possible that in the step of etching, the etching is performed using a mixed gas of a fluorocarbon gas and oxygen as a raw material gas.

The mixed gas of the fluorocarbon gas and the oxygen is a gas used for etching of e.g., silicon. Consequently, when used as the raw material gas, it is advantageous in that the need to provide a gas dedicated for etching of SiC is eliminated.

At this time, it is possible that after the step of separating and before the step of etching, a step of annealing is performed in which the separation surface of the joined substrate or the separated substrate, which is to be subjected to the step of etching, is annealed at a temperature of 1000°C or higher in a hydrogen atmosphere.

In this way, when hydrogen annealing is performed and the etching is then performed, the uneven shape of the separation surface roughened by separation is modified by hydrogen annealing before etching, resulting in planarization to a certain extent. Accordingly, in the etching step, it becomes easier to further improve the planarity of the separation surface.

At this time, it is possible that in the step of etching, the separation surface of the joined substrate is plasma-etched, and
in the step of performing epitaxial growth, an epitaxial layer is grown on the separation surface etched of the joined substrate.

In this way, when an epitaxial layer is grown on the etched separation surface of the joined substrate, a required film thickness of the SiC layer can be secured, and by forming the device in the epitaxial layer, the device can be of higher quality.

Moreover, the present invention provides a semiconductor substrate comprising:
a support substrate; and
a 4H-SiC layer bonded onto a surface of the support substrate, wherein
the 4H-SiC layer is bonded to the support substrate via a silicon thin film, and has a surface that is subjected to etching treatment.

With such a semiconductor substrate, the surface of the 4H-SiC layer of the semiconductor substrate is subjected to etching treatment, and the surface thereof is planarized; as a result, the epitaxial layer can be formed without performing a high-cost planarization treatment such as CMP, resulting in the high-quality and inexpensive semiconductor substrate.

Further, when the 4H-SiC layer is bonded to the support substrate via the silicon thin film, the silicon thin film may also serve as an underlayer for epitaxial growth of the 4H-SiC, thereby enhancing the bonding between the 4H-SiC and the support substrate. In addition, even when the polycrystalline body or the sintered body of SiC is used for the support substrate, the bonding therebetween can be enhanced. Consequently, the bonding between the support substrate and the 4H-SiC layer is enhanced.

Furthermore, the present invention provides a semiconductor device comprising the semiconductor substrate described above.

Such a semiconductor device is provided with a high-quality and inexpensive semiconductor substrate described above, resulting in a high-quality and inexpensive device with high reliability.

### ADVANTAGEOUS EFFECTS OF INVENTION

As described above, according to the inventive method for producing a semiconductor substrate, the semiconductor substrate having less expensive and higher quality can be produced by employing the 4H-SiC separation technique; as a result, the production cost of the semiconductor substrate can be reduced. Moreover, the inventive semiconductor substrate is inexpensive and of high quality. Furthermore, the inventive semiconductor device is also inexpensive and of high quality.

Moreover, according to the configuration of the present invention, the substrate after separation can be effectively used, thereby enabling the reduction in the cost of the SiC substrate.

### BRIEF DESCRIPTION OF DRAWINGS

[FIG. 1] is a schematic view of a semiconductor substrate according to the present invention.
[FIG. 2] is a flow diagram of a method for producing a semiconductor substrate according to the present invention.

### DESCRIPTION OF EMBODIMENTS

Hereinafter, the present invention will be described in detail. However, the present invention is not limited thereto.

As described above, by employing a 4H-SiC separation technique, a method for producing a semiconductor substrate of less expensive and higher quality, a semiconductor substrate of less expensive and higher quality, and a semiconductor device of less expensive and higher quality are desired.

To solve the above problem, the present inventors have earnestly studied and found out that, by employing a method for producing a semiconductor substrate, the method including the steps of irradiating a surface of a 4H-SiC substrate with a laser to form, within the 4H-SiC substrate, an amorphous layer composed of amorphized silicon and carbon, bonding the surface of the 4H-SiC substrate and a bonding surface of another support substrate via a thin film, in which the thin film is formed on at least one of the surface of the 4H-SiC substrate subjected to the laser irradiation or the bonding surface of the support substrate, to obtain a bonded substrate, separating the 4H-SiC substrate at the amorphous layer from the bonded substrate, thereby dividing the bonded substrate into a joined substrate in which a surface layer of the 4H-SiC substrate is transferred as a 4H-SiC layer on the support substrate, and a separated substrate that is the 4H-SiC substrate after the surface layer has been separated, etching a separation surface of at least one of the joined substrate or the separated substrate, both of which have been subjected to the step of separating, by plasma etching, and performing epitaxial growth on at least one of the joined substrate or the separated substrate, a method for producing a semiconductor substrate, in which a semiconductor substrate of less expensive and higher quality can be produced, can be provided by employing a 4H-SiC separation technique. This finding has led to the completion of the present invention.

Moreover, the present inventors have earnestly studied to solve the above problem, and found out that, by employing a semiconductor substrate including a support substrate, and a 4H-SiC layer bonded onto a surface of the support substrate, in which the 4H-SiC layer is bonded to the support substrate via a silicon thin film, and has a surface that is subjected to etching treatment, a semiconductor substrate of less expensive and higher quality can be provided. This finding has led to the completion of the present invention.

Further, the present inventors have earnestly studied to solve the above problem, and found out that, by employing a semiconductor device including the semiconductor substrate described above, a semiconductor device of less expensive and higher quality can be provided. This finding has led to the completion of the present invention.

In this way, the present invention relates to a method for producing a semiconductor substrate, a semiconductor substrate, and a semiconductor device, and more specifically, to a method for producing a SiC wafer including a substrate separation technique with a laser, and reuse of the substrate after bonding and separating. This provides a SiC substrate, including 4H-SiC, of higher quality and lower cost.

Hereinafter, the suitable embodiment of the present invention will be described with reference to the drawings.

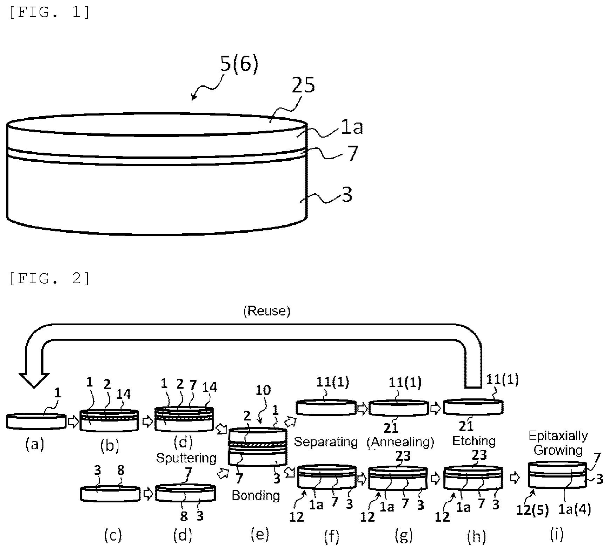

To begin with, a configuration of a semiconductor substrate 5 is described with reference to FIG. 1.

As shown in FIG. 1, the semiconductor substrate 5 according to the embodiment of the present invention is provided with a support substrate 3 and a 4H-SiC layer 1a bonded onto a surface of the support substrate 3, in which the 4H-SiC layer 1a is bonded to the support substrate 3 via a thin film 7.

The support substrate 3 is a substrate to support the 4H-SiC layer 1a, and as long as the substrate has sufficient strength to support the 4H-SiC layer 1a and does not cause an unintended reaction with the thin film 7, materials and dimensions thereof can be selected as appropriate. Specifically, a bulk 4H-SiC that uses the same material as the 4H-SiC layer 1a can be exemplified; however, taking price into consideration, the SiC substrate produced by sintering or a polycrystalline SiC substrate, which are less expensive than the bulk 4H-SiC, may be used.

The 4H-SiC layer 1a is a single-crystal layer of 4H-SiC and is bonded to the surface of the support substrate 3. For this bonding, the thin film 7 made of silicon or the like is provided on the bonding surface between the 4H-SiC layer 1a and the support substrate 3. By bonding the 4H-SiC layer 1a and the support substrate 3 via the thin film 7 made of silicon or the like, a strong bond can be achieved.

The material of the thin film 7 is not particularly limited as long as the material can bond to both the 4H-SiC layer 1a and the support substrate 3, for example, a silicon thin film can be exemplified. In the following description, unless otherwise specified, the present invention will be described using, as an example, a case in which the silicon thin film is used as the thin film 7.

Moreover, the 4H-SiC layer 1a has a surface 25 that has been subjected to an etching treatment. As the 4H-SiC layer 1a has the surface 25 that has been subjected to an etching treatment, the surface 25 becomes planar, allowing the epitaxial layer to be formed without a high-cost planarization treatment such as CMP. Accordingly, an inexpensive and high-quality semiconductor substrate 5 can be obtained.

The 4H-SiC layer 1a may be either the bulk 4H-SiC or a 4H-SiC epitaxial layer, as long as it is a single-crystal layer.

The thickness of the 4H-SiC layer 1a may be set to a minimum value sufficient to maintain the form of the layer, allow device formation, and prevent removal thereof by etching, polishing, or the like during the process. In contrast, the maximum thickness is a thickness in which an unnecessary portion not used in device formation, for example, is minimized. The film thickness can be, for example, 0.01 µm to 400 µm.

Next, a configuration of a semiconductor device 6 will be described with reference to FIG. 1.

The semiconductor device 6, shown in FIG. 1, is provided with the semiconductor substrate 5.

As the specific semiconductor device 6, the semiconductor substrate 5, in particular, in which a desired semiconductor device is formed on the 4H-SiC layer 1a, can be exemplified. Naturally, the semiconductor device 6 can also be diced into individual chips.

By providing the semiconductor device 6 with the inexpensive and high-quality semiconductor substrate 5, the semiconductor device 6 also becomes inexpensive, high-quality, and highly reliable.

Next, with reference to FIG. 2, an overview of the inventive method for producing a semiconductor substrate 5 will be described.

First, as shown in FIG. 2(a), a 4H-SiC substrate 1 is provided. Here, a bulk single-crystal 4H-SiC is exemplified as the 4H-SiC substrate 1; however, a 4H-SiC epitaxial substrate may also be used.

In this step, the surface layer of the 4H-SiC substrate 1 is transferred to the support substrate 3, and a separated substrate 11, which remained after the transfer in the end, may be reused as the 4H-SiC substrate 1. These 4H-SiC substrates 1 are desirably formed by epitaxial growth using CVD.

Next, the surface of the 4H-SiC substrate 1 is irradiated with a laser to break a bond between silicon and carbon near the surface of the 4H-SiC substrate 1, thereby forming an amorphous layer 2 composed of silicon and carbon, each present in an amorphized state, as shown in FIG. 2(b) (step of irradiating with a laser).

At this time, by adjusting a focal depth of the laser irradiation, the amorphous layer 2, in which silicon and carbon are each present in the amorphized state, can be formed at a predetermined depth.

A type of laser to be irradiated is not particularly limited as long as the laser can form the amorphous layer 2 at a desired depth in the 4H-SiC substrate 1, but a YAG laser can be exemplified. In the case of the YAG laser, the second harmonic (SHG: Second harmonic generation, wavelength of 532 nm) can be exemplified as an irradiation wavelength.

Next, as shown in FIG. 2(c), a support substrate 3, which is different from the 4H-SiC substrate 1, is provided as the support substrate 3. Although the support substrate 3 may be a single-crystal 4H-SiC having the same structure as the 4H-SiC substrate 1, it is preferable to use, for example, a sintered SiC produced by sintering, polycrystalline SiC, or the like, in consideration of cost.

Next, as shown in FIG. 2(d), after forming the thin film 7 on at least one of a surface 14 of the 4H-SiC substrate 1 subjected to the laser irradiation step or a bonding surface 8 of the support substrate 3, the surface 14 of the 4H-SiC substrate 1 and the bonding surface 8 of the support substrate 3 are bonded via the thin film 7 to obtain a bonded substrate 10, as shown in FIG. 2(e) (Step of bonding). Note that, in FIG. 2(d), a case in which the thin films 7 are formed on both the 4H-SiC substrate 1 and the support substrate 3 is exemplified.

As for the thin film 7, it is preferable to form the silicon thin film and perform bonding via this film.

The silicon thin film may be used as an underlayer at times for epitaxial growth of 4H-SiC; thus is easily bonded to 4H-SiC, and also is easily bonded to the polycrystalline body or sintered body of SiC. Accordingly, by providing the support substrate 3 made of the polycrystalline SiC, and the like, which is less expensive than the single crystal SiC, forming thin silicon on the bonding surface 8, and performing bonding via the silicon, it becomes possible to bond even SiC that is difficult to bond.

Regarding a specific method for forming the thin film 7, a sputtering method in which Ar ions are irradiated onto a target, being silicon as the target, to form the film is effective because high-temperature heating to the substrate on which the film is to be formed is not required and the SiC surface of the bonding surface 8 is not roughened.

Moreover, as a method for bonding the 4H-SiC substrate 1 and the support substrate 3 via the thin film 7, for example, a room-temperature bonding can be exemplified.

Next, as shown in FIG. 2(f), by separating the 4H-SiC substrate 1 at the amorphous layer 2 of the bonded substrate 10, the bonded substrate 10 is divided into a joined substrate 12 in which the surface layer of the 4H-SiC substrate 1 is transferred as the 4H-SiC layer 1a on the support substrate 3, and the separated substrate 11 that is the 4H-SiC substrate 1 after the surface layer has been separated (Step of separating).

Specifically, in the step of separating, the 4H-SiC substrate 1 can be separated by performing light irradiation, impact application, or a combined treatment thereof to the amorphous layer 2.

When performing the light irradiation, the bonded substrate 10 is irradiated with the light, and the light is absorbed at the amorphous layer 2, which includes carbon formed in the step of irradiating with a laser. With this absorbing portion as a starting point, the 4H-SiC substrate 1 is separated, and thus, the bonded substrate 10 is divided into a joined substrate 12 in which the surface layer of the 4H-SiC substrate 1 is transferred as the 4H-SiC layer 1a on the support substrate 3, and the separated substrate 11 that is the 4H-SiC substrate 1 after the surface layer has been separated.

In this way, by irradiating the amorphous layer 2 with the light and making that layer absorb the light, energy required for separation can be directly imparted to the amorphous layer 2.

A light source for irradiation is not particularly limited as long as energy is imparted to the amorphous layer 2 in an amount sufficient to separate the 4H-SiC substrate 1 from the amorphous layer 2, but the YAG laser can be exemplified. When the YAG laser is used as the light source, the fundamental wavelength (1064 nm) can be exemplified as the wavelength of the irradiated light.

In the step of separating, when applying an impact to the amorphous layer 2, the separation can be achieved simply by inserting, for example, a thin metal blade-like object into the amorphous layer 2 without irradiating the light.

In this way, a method for applying the impact to the amorphous layer 2 to separate is advantageous in that the facility required for separation can be simplified.

Furthermore, the separation can also be achieved by combining the light irradiation with the impact. Specifically, in addition to irradiating the light, separation may be performed, for example, by inserting a thin metal blade-like object into the amorphous layer 2 and applying the impact thereto. In this case, compared to performing light irradiation or impact application alone, the time required for separation can be shortened.

A separation surface 23 of the joined substrate 12 obtained through the above separation has a roughened surface; therefore, it may be preferable to planarize the surface in some cases when the epitaxial layer is desired to be formed in a later step. In addition, the separated substrate 11 can be reused by repeating the step of implanting ions, the step of bonding, and the step of separating, thereby allowing the surface layers to be transferred to a plurality of the support substrates 3. However, the separation surface 21 has the surface roughened; it is required to planarize the surface to bond to the support substrate 3. Consequently, a procedure for planarizing the separation surfaces 23 and 21 is described below.

To begin with, as shown in FIG. 2(h), at least one of the separation surface 23 of the joined substrate 12 or the separation surface 21 of the separated substrate 11 after the step of separating is etched by plasma etching (Step of etching).

Note that, in FIG. 2, although a case where both the separation surface 23 of the joined substrate 12 and the separation surface 21 of the separated substrate 11 are etched is exemplified, at least one of those may be etched. For example, in a case where the epitaxial layer can be formed without planarizing the separation surface 23 of the joined substrate 12, or in a case where the 4H-SiC layer 1a is the epitaxial layer and it is not required to further form the epitaxial layer, only the separation surface 21 of the separated substrate 11 may be etched.

By plasma etching at least one of the separation surface 23 of the joined substrate 12 or the separation surface 21 of the separated substrate 11, a surface of SiC, which is a hard-to-process material, can be planarized at a lower cost compared to CMP, etc.

In the step of etching, the etching can be performed using a mixed gas of a fluorocarbon gas and oxygen as a raw material gas. The specific fluorocarbon gas is preferably CHF₃ or CF₄. The mixed gas of the fluorocarbon gas and oxygen is the gas used for etching silicon, and the like; consequently, using this gas as the raw material gas eliminates the need to provide the gas specifically for SiC etching, which is advantageous.

A plasma form in the step of etching is not particularly limited as long as it is optimized by an apparatus, but RF plasma can be exemplified. Note that in general, SiC is not etched with such a mix gas of the fluorocarbon gas and the oxygen gas, but the separation surfaces 23 and 21 are weakened by the laser irradiation in the step of irradiating with a laser, and the surface layers thereof are damaged layers, and thus these layers including the separation surfaces 23 and 21 can be removed by etching, thus planarized. Furthermore, the separation surfaces 23 and 21 may be weakened through damage caused by the laser irradiation and plasma treatment using H₂ gas.

Note that after the step of separating and before the step of etching, as shown in FIG. 2(g), the separation surface 23 of the joined substrate 12 or the separation surface 21 of the separated substrate 11, which is to be subjected to the step of etching, may be annealed at a temperature of 1000°C or higher in a hydrogen atmosphere (Step of annealing). The upper limit of the annealing temperature is not particularly limited, but can be 2000°C or less.

By performing a hydrogen annealing in the step of annealing and then performing the step of etching, the uneven shape of the separation surface 23 or the separation surface 21, which has been roughened due to separation, is modified through the hydrogen annealing before etching and partially planarized. As a result, the planarity of the separation surface 23 or the separation surface 21 can be more readily improved in the step of etching.

The separated substrate 11, after the step of separation, can be reused as the 4H-SiC substrate 1 for transferring the 4H-SiC onto the support substrate 3 by further repeating the steps of irradiating with a laser, bonding, and separating until the thickness becomes too thin to allow further separation.

Here, when the separation surface 21 of the separated substrate 11 has been etched in the step of etching, the separation surface 21 is planarized by the etching, and thus, the support substrate 3 can be bonded to the separation surface 21 without performing a high-cost planarization treatment such as CMP.

Next, the epitaxial growth is performed on at least one of the joined substrate 12 or the separated substrate 11 (Step of performing epitaxial growth).

In FIG. 2(i), an example is shown in which an epitaxial layer 4 of 4H-SiC is grown on the 4H-SiC layer 1a of the joined substrate 12.

Here, when the separation surface 23 of the 4H-SiC layer 1a is etched in the step of etching, the separation surface 23 is planarized by etching; consequently, the epitaxial layer can be formed on the separation surface 23 without performing the high-cost planarization treatment such as CMP. This enables the joined substrate 12 to serve as an inexpensive and high-quality semiconductor substrate 5.

Note that, when the 4H-SiC layer 1a is the epitaxial layer and the thickness of the transferred 4H-SiC layer 1a is sufficient for forming the device in the subsequent step, it is not necessarily required to conduct the step of performing epitaxial growth on the joined substrate 12 shown in FIG. 2(i).

On the other hand, when the 4H-SiC layer 1a is not the epitaxial layer, or the 4H-SiC layer 1a is the epitaxial layer but the film thickness is not sufficient to form the device when transferred in the step of separating, it is preferable to perform the step of performing epitaxial growth to the joined substrate 12. In this case, it is preferable to smooth the separation surface 23 in the step of etching before conducting the step of performing epitaxial growth on the joined substrate 12.

Specifically, as shown in FIG. 2(h), it is preferable to perform the plasma etching on the separation surface 23 of the joined substrate 12 in the step of etching. In addition, on the etched separation surface 23 of the joined substrate 12, in the step of performing epitaxial growth as shown in FIG. 2(i), it is preferable to grow the epitaxial layer 4 on the etched separation surface 23 of the joined substrate 12.

In this way, when the epitaxial layer 4 is grown on the etched separation surface 23 of the joined substrate 12, the device can be of higher quality by forming the device on the epitaxial layer 4.

### EXAMPLE

Hereinafter, the present invention will be specifically described with reference to Example. However, the present invention is not limited thereto.

After a 4H-SiC substrate 1 was subjected to a step of irradiating with a laser, a formation of a silicon thin film and bonding (Step of bonding), a step of separating, and a step of etching, and further subjected to the step of irradiating with a laser and the step of bonding, a separated substrate 11 was attempted to be reused as the 4H-SiC substrate 1.

### (Example)

First, as a 4H-SiC substrate 1, a 4H-SiC single crystal substrate was provided with a diameter of 200 mm, a thickness of 355 µm, n-type, a resistivity of 10 Ω·cm, and a 4° off-angle from a (0001) plane. This substrate was then subjected to a step of irradiating with a laser using a light source that irradiates a laser beam having a wavelength of 1064 nm as light with a transmittable wavelength to form an amorphous layer 2. In this case, a YAG laser was used for this laser beam, and a laser irradiation focal depth was adjusted to irradiate a second harmonic generation (SHG, wavelength of 532 nm) onto the 4H-SiC substrate 1, thereby forming the amorphous layer 2 within the substrate.

Next, as a support substrate 3, a polycrystalline SiC substrate having a same diameter as the 4H-SiC substrate 1 was provided, and as a step of bonding, Ar ion was irradiated to silicon as a target, and the silicon was formed as a thin film 7 on both the 4H-SiC substrate 1 and the support substrate 3 by sputtering. At this time, a thickness of the silicon thin film was set to 20 nm. Subsequently, the 4H-SiC substrate 1 was bonded to the support substrate 3 at room temperature to obtain a bonded substrate 10.

Subsequently, a YAG laser (wavelength 1064 nm) was used as a step of separating, and the amorphous layer 2 was irradiated with light, and excited by aligning the focal position with the amorphous layer 2, thereby separating the bonded substrate 10 into a joined substrate 12 and a separated substrate 11.

As a step of performing epitaxial growth, 4H-SiC was epitaxially grown on this joined substrate 12 using a Hot-wall type CVD apparatus, with H₂ as a carrier gas, SiH₄ and C₃H₈ as raw material gases to obtain a semiconductor substrate 5. A temperature at this time was 1600°C, and a pressure in a furnace was 7 kPa.

In this way, as a step of etching, a separation surface 21 of the separated substrate 11, which was obtained when the semiconductor substrate 5 was obtained, was subjected to RF plasma etching treatment under the following conditions: raw material gases of CHF₃ and O₂ at 100 sccm and 10 sccm, respectively; a pressure of 100 Torr (13332.2 Pa); and a RF power of 500W.

When the separated substrate 11, after the step of etching, was subjected to the step of irradiating with a laser and the step of bonding once again in a previous flow for reuse, the support substrate 3 was successfully bonded to the separation surface 21 of the separated substrate 11, and the bonded substrate 10 was successfully obtained in the same way.

As described above, according to Example of the present invention, by irradiating the 4H-SiC substrate 1 with the laser to form the amorphous layer 2, and then bonding the support substrate 3 thereto via the thin film 7, and separating the 4H-SiC substrate 1 at the amorphous layer 2, the joined substrate 12 was successfully obtained in which a surface layer of the 4H-SiC substrate 1 was transferred on the support substrate 3 as the 4H-SiC layer 1a. Moreover, the separated substrate 11 was subjected to the etching treatment and was successfully reused repeatedly as the 4H-SiC substrate 1. Therefore, the present invention enables a significant reduction in production cost of the semiconductor substrate using SiC.

The present description includes the following embodiments.
[1]: A method for producing a semiconductor substrate, the method comprising the steps of:
   irradiating a surface of a 4H-SiC substrate with a laser to form, within the 4H-SiC substrate, an amorphous layer composed of amorphized silicon and carbon;
   bonding the surface of the 4H-SiC substrate and a bonding surface of another support substrate via a thin film, in which the thin film is formed on at least one of the surface of the 4H-SiC substrate subjected to the laser irradiation or the bonding surface of the support substrate, to obtain a bonded substrate;
   separating the 4H-SiC substrate at the amorphous layer from the bonded substrate, thereby dividing the bonded substrate into a joined substrate in which a surface layer of the 4H-SiC substrate is transferred as a 4H-SiC layer on the support substrate, and a separated substrate that is the 4H-SiC substrate after the surface layer has been separated;
   etching a separation surface of at least one of the joined substrate or the separated substrate, both of which have been subjected to the step of separating, by plasma etching; and
   performing epitaxial growth on at least one of the joined substrate or the separated substrate.
[2]: The method for producing a semiconductor substrate according to the above [1], wherein
   in the step of separating, the 4H-SiC substrate is separated by performing light irradiation, impact application, or a combination thereof to the amorphous layer.
[3]: The method for producing a semiconductor substrate according to the above [1] or [2], wherein
   in the step of bonding, a silicon thin film is formed as the thin film, and bonding is performed via the silicon thin film.
[4]: The method for producing a semiconductor substrate according to the above [3], wherein
   in the step of bonding, the silicon thin film is formed by a sputtering method using silicon as a target.
[5]: The method for producing a semiconductor substrate according to any of the above [1] to [4], wherein
   in the step of etching, the etching is performed using a mixed gas of a fluorocarbon gas and oxygen as a raw material gas.
[6]: The method for producing a semiconductor substrate according to any of the above [1] to [5], wherein
   after the step of separating and before the step of etching, a step of annealing is performed in which the separation surface of the joined substrate or the separated substrate, which is to be subjected to the step of etching, is annealed at a temperature of 1000°C or higher in a hydrogen atmosphere.
[7]: The method for producing a semiconductor substrate according to any of the above [1] to [6], wherein
   in the step of etching, the separation surface of the joined substrate is plasma-etched, and
   in the step of performing epitaxial growth, an epitaxial layer is grown on the separation surface etched of the joined substrate.
[8]: A semiconductor substrate comprising:
   a support substrate; and
   a 4H-SiC layer bonded onto a surface of the support substrate, wherein
   the 4H-SiC layer is bonded to the support substrate via a silicon thin film, and has a surface that is subjected to etching treatment.
[9]: A semiconductor device comprising the semiconductor substrate according to the above [8].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a semiconductor substrate, the method comprising the steps of:
irradiating a surface of a 4H-SiC substrate with a laser to form, within the 4H-SiC substrate, an amorphous layer composed of amorphized silicon and carbon;
bonding the surface of the 4H-SiC substrate and a bonding surface of another support substrate via a thin film, in which the thin film is formed on at least one of the surface of the 4H-SiC substrate subjected to the laser irradiation or the bonding surface of the support substrate, to obtain a bonded substrate;
separating the 4H-SiC substrate at the amorphous layer from the bonded substrate, thereby dividing the bonded substrate into a joined substrate in which a surface layer of the 4H-SiC substrate is transferred as a 4H-SiC layer on the support substrate, and a separated substrate that is the 4H-SiC substrate after the surface layer has been separated;
etching a separation surface of at least one of the joined substrate or the separated substrate, both of which have been subjected to the step of separating, by plasma etching; and
performing epitaxial growth on at least one of the joined substrate or the separated substrate.

2. The method for producing a semiconductor substrate according to claim 1, wherein
in the step of separating, the 4H-SiC substrate is separated by performing light irradiation, impact application, or a combination thereof to the amorphous layer.

3. The method for producing a semiconductor substrate according to claim 1, wherein
in the step of bonding, a silicon thin film is formed as the thin film, and bonding is performed via the silicon thin film.

4. The method for producing a semiconductor substrate according to claim 3, wherein
in the step of bonding, the silicon thin film is formed by a sputtering method using silicon as a target.

5. The method for producing a semiconductor substrate according to claim 1, wherein
in the step of etching, the etching is performed using a mixed gas of a fluorocarbon gas and oxygen as a raw material gas.

6. The method for producing a semiconductor substrate according to claim 1, wherein
after the step of separating and before the step of etching, a step of annealing is performed in which the separation surface of the joined substrate or the separated substrate, which is to be subjected to the step of etching, is annealed at a temperature of 1000°C or higher in a hydrogen atmosphere.

7. The method for producing a semiconductor substrate according to any one of claims 1 to 6, wherein
in the step of etching, the separation surface of the joined substrate is plasma-etched, and
in the step of performing epitaxial growth, an epitaxial layer is grown on the separation surface etched of the joined substrate.

8. A semiconductor substrate comprising:
a support substrate; and
a 4H-SiC layer bonded onto a surface of the support substrate, wherein
the 4H-SiC layer is bonded to the support substrate via a silicon thin film, and has a surface that is subjected to etching treatment.

9. A semiconductor device comprising the semiconductor substrate according to claim 8.
